# EUROPEAN PATENT APPLICATION

(11) **EP 4 686 960 A1**
(43) Date of publication of application: **04.02.2026**
(21) Application number: 25192392.6
(22) Date of filing: 29.07.2025
(51) Int. Cl.: G01S 17/89, G01S 17/894, H04N 25/77, H04N 25/705, H10F 39/00

(54) **DISTANCE IMAGE CAPTURING ELEMENT AND DISTANCE IMAGE CAPTURING DEVICE**

(30) Priority: 31.07.2024 JP 2024124431
(71) Applicant: Toppan Holdings Inc., Tokyo 110-0016 (JP)
(72) Inventor: OOKUBO, Yu, Tokyo, 110-0016 (JP)
(74) Representative: TBK

(57) **Abstract**

A distance image capturing element includes a pixel array in which a plurality of pixels, each having a photoelectric conversion element and N (N≥2) charge accumulation units, are arranged, and a pixel drive circuit configured to drive the plurality of pixels to distribute and accumulate electric charges in each of the charge accumulation units, in which the pixel includes the N transfer transistors configured to transfer the electric charges from the photoelectric conversion element to each of the N charge accumulation units, the N reset transistors configured to reset the charge accumulation units, and the N control transistors connected between the reset transistors and the power supply line, and in the pixel, at least one control terminal among the N control transistors is connected to a control wiring line capable of controlling an ON state of the control transistors, and remaining control terminals other than the at least one control terminal are connected to fix the control transistors in an OFF state.

## Description

### Field of the Invention

The present invention relates to a distance image capturing element and a distance image capturing device.

### Description of Related Art

A distance image capturing device of a time of flight (hereinafter, referred to as "TOF") type that uses a known speed of light and measures a distance between a measurement instrument and a target object based on a flight time of light in a space (measurement space) has been implemented (refer to, for example, Japanese Patent No. 4235729). In an image capturing device, such as a distance image capturing device, captures an image by using, for example, a distance image capturing element including a photoelectric conversion element such as a photodiode. In addition, the distance image capturing device of the TOF type is known which includes a photoelectric conversion element for converting an incident amount of light into electric charges and a distance image capturing element for distributing and accumulating the electric charges converted by the photoelectric conversion element in a plurality of charge accumulation units.

### SUMMARY OF THE INVENTION

### [Problems To Be Solved by Invention]

However, there is a case where each pixel of a distance image capturing element is used by being added to each other, and in such a case, it is necessary to add a control transistor for adding each pixel and for erasing the added electric charges. In the distance image capturing element of the related art, in a case where (2×2) pixels are desired to perform addition, a control transistor is added thereto at a ratio of one per four pixels, and in a case where (4×4) pixels are desired to perform addition, a control transistor is added thereto at a ratio of one per 16 pixels. That is, in the distance image capturing element of the related art, in a case where (K×K) pixels perform addition, it is necessary to add one control transistor to (K×K) pixels.

However, in the distance image capturing element of the related art, in a case where addition of a plurality of pixels is viewed from one pixel as described above, pixels in which control transistors are present and pixels in which control transistors are not present are mixed, which causes the symmetry of pixels to collapse and the uniformity of pixel output characteristics to decrease. Therefore, in the distance image capturing element of the related art, the uniformity of pixel output characteristics decreases, and accordingly, accuracy of distance measurement can be reduced.

The present invention is to solve the above-described problem, and an object of the present invention is to provide a distance image capturing element and a distance image capturing device capable of making pixel output characteristics uniform and improving accuracy of distance measurement.

### [Means for Solving Problems]

In order to solve the above-described problem, one aspect of the present invention is a distance image capturing element including a pixel array in which a plurality of pixels are arranged, each pixel including a photoelectric conversion element configured to generate electric charges corresponding to incident light and N (where, N is an integer of 2 or more) charge accumulation units configured to accumulate the electric charges, and a pixel drive circuit configured to drive the plurality of pixels to distribute and accumulate the electric charges in each of the charge accumulation units, in which each of the plurality of pixels includes N transfer transistors configured to transfer the electric charges from the photoelectric conversion element to each of the N charge accumulation units, N reset transistors which are reset transistors corresponding to each of the N charge accumulation units and are configured to reset the charge accumulation units to a predetermined reset potential supplied from a power supply line, and N control transistors which are control transistors corresponding to the N reset transistors and are connected between the reset transistors and the power supply line, and in each of the plurality of pixels, at least one control terminal among the N control transistors is connected to a control wiring line configured to control a conductive state of the control transistor, and remaining control terminals other than the at least one control terminal among the N control transistors are connected to fix the remaining control transistors in a non-conductive state.

In the distance image capturing element according to one aspect of the present invention, the number of the N charge accumulation units may be an even number.

In the distance image capturing element according to one aspect of the present invention, the pixel array may include K types (where K is an integer of N or less) of the pixels, and each of the K types of pixels may have different positions of the control transistors connected to the control wiring line among the N control transistors.

In the distance image capturing element according to one aspect of the present invention, the K types of pixels may be disposed in one row, and a unit pixel structure composed of K types × K matrixes may be formed on a semiconductor substrate.

In the distance image capturing element according to one aspect of the present invention, the pixel array may be formed by repeating the unit pixel structure.

In the distance image capturing element according to one aspect of the present invention, the pixel may include a source follower transistor configured to convert the electric charges into an electrical signal, a selection transistor configured to select reading of the electrical signal of the pixel, and a charge emission transistor configured to emit the electric charges from the photoelectric conversion element.

In the distance image capturing element according to one aspect of the present invention, the pixel array may include K types (where K is an integer of N or less) of the pixels, and each of the K type of pixels may have different positions of the control transistors connected to the control wiring line among the N control transistors. The K types of pixels may be disposed in one row, and a unit pixel structure composed of K types × K matrixes may be formed on a semiconductor substrate. The pixel array may be formed by repeating the unit pixel structure. The pixel may includes a source follower transistor configured to convert the electric charges into an electrical signal, a selection transistor configured to select reading of the electrical signal of the pixel, and a charge emission transistor configured to emit the electric charges from the photoelectric conversion element.

One aspect of the present invention is a distance image capturing device including a light source configured to irradiate a subject with a light pulse, a light receiver including the distance image capturing element described above, and a distance image processor configured to cause the pixel drive circuit to accumulate the electric charges in each of the charge accumulation units and calculate a distance to the subject based on an amount of the electric charges accumulated in each of the charge accumulation units.

### [Effect of invention]

According to the present invention, it is possible to make pixel output characteristics uniform and improve accuracy of distance measurement.

### BRIEF DESCRIPTION OF THE DRAWINGS

FIG. 1 is a block diagram showing an example of a distance image capturing device according to the present embodiment.
FIG. 2 is a block diagram showing an example of a distance image capturing element according to the present embodiment.
FIG. 3 is a diagram showing a layout example of pixels in the present embodiment.
FIG. 4 is a first diagram showing an example of a pixel in the present embodiment.
FIG. 5 is a second diagram showing an example of a pixel in the present embodiment.
FIG. 6 is a third diagram showing an example of a pixel in the present embodiment.
FIG. 7 is a fourth diagram showing an example of a pixel in the present embodiment.
FIG. 8 is a diagram showing an example of a pixel array in the present embodiment.
FIG. 9 is a timing chart showing an example of an operation of a normal mode of a distance image capturing element according to the present embodiment.
FIG. 10 is a timing chart showing an example of an operation of a binning mode of a distance image capturing element according to the present embodiment.

### DETAILED DESCRIPTION OF THE INVENTION

Hereinafter, a distance image capturing element and a distance image capturing device according to an embodiment of the present invention will be described with reference to the drawings.

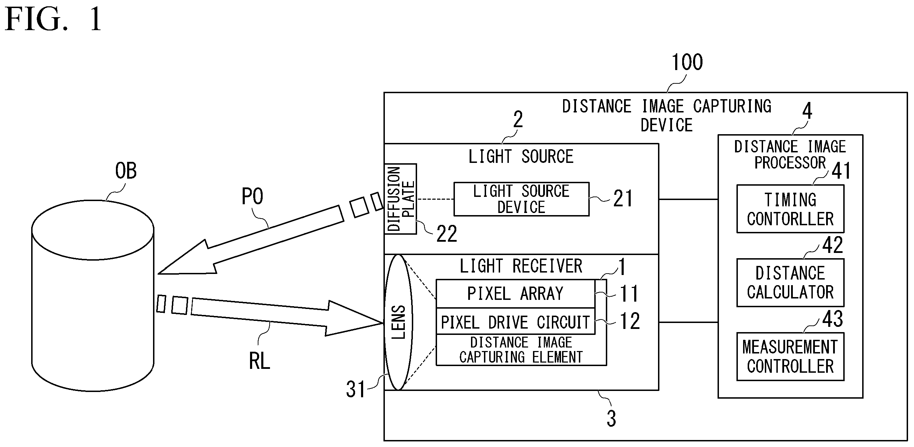

FIG. 1 is a block diagram showing an example of a distance image capturing device 100 according to the present embodiment.

As shown in FIG. 1, the distance image capturing device 100 includes a light source 2, a light receiver 3, and a distance image processor 4. In FIG. 1, a subject OB that is a target object of which distance is measured by using the distance image capturing device 100 is also shown.

The light source 2 emits a light pulse PO to a space of an imaging target in which the subject OB of a target to which a distance is to be measured from the distance image capturing device 100 exists, under the control of the distance image processor 4. The light source 2 is, for example, a surface-emitting type semiconductor laser module such as a vertical cavity surface emitting laser (VCSEL). The light source 2 includes a light source device 21 and a diffusion plate 22.

The light source device 21 is a light source that emits laser light in a near-infrared wavelength band (for example, a wavelength band having a wavelength of 850 nm to 940 nm) as the light pulse PO to be emitted to the subject OB. The light source device 21 is, for example, a semiconductor laser light emitting element. The light source device 21 emits pulse-type laser light under the control of the measurement controller 43.

The diffusion plate 22 is an optical component that diffuses the laser light in the near-infrared wavelength band emitted by the light source device 21 to a size of a surface for emitting the laser light to the subject OB. The pulse-type laser light diffused by the diffusion plate 22 is emitted as the light pulse PO, and emitted to the subject OB.

The light receiver 3 receives reflected light RL of the light pulse PO reflected by the subject OB of a target to which a distance is to be measured from the distance image capturing device 100 and outputs a pixel signal corresponding to the received reflected light RL. The light receiver 3 includes a lens 31 and a distance image capturing element 1.

The lens 31 is an optical lens that guides the incident reflected light RL to the distance image capturing element 1. The lens 31 emits the incident reflected light RL to the distance image capturing element 1 side and causes a pixel array 11 provided in a light-receiving region of the distance image capturing element 1 to receive (to receive) the incident reflected light RL.

The distance image capturing element 1 is an image-capturing element used for the distance image capturing device 100.

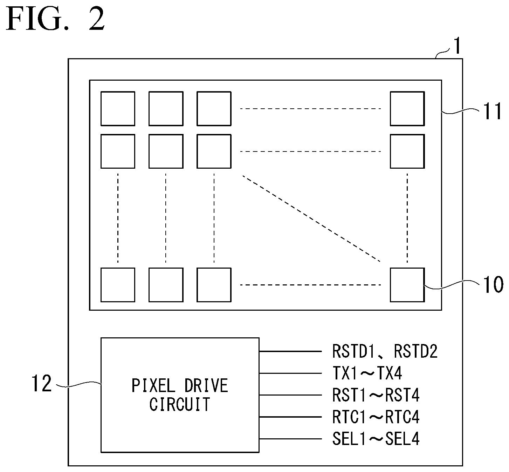

The configuration of the distance image capturing element 1 will be described with reference to FIG. 2.

FIG. 2 is a block diagram showing an example of the distance image capturing element 1 according to the present embodiment.

As shown in FIG. 2, the distance image capturing element 1 includes the pixel array 11 including a plurality of pixels 10 in a two-dimensional light-receiving region, and a pixel drive circuit 12 that controls each of the pixels 10.

The pixels 10 included in the pixel array 11 are provided with, for example, one photoelectric conversion element PD, a plurality of charge accumulation units CS corresponding to the one photoelectric conversion element PD, and a constituent element that distributes electric charges to each charge accumulation unit CS. A detailed configuration of the pixel 10 according to the present embodiment will be described below with reference to the drawings.

The pixel drive circuit 12 distributes and accumulates electric charges to each of charge accumulation units CS at a predetermined accumulation timing synchronized with emission of the light pulse PO.

The pixel drive circuit 12 switches a pixel region to a normal mode (single pixel), a binning mode in which a plurality of pixels 10 are added and used, and the like, according to an image-capturing scene (measurement scene).

Returning to the description of FIG. 1, the distance image processor 4 controls the distance image capturing device 100 to calculate a distance to the subject OB. The distance image processor 4 measures a distance to the subject OB existing in a measurement space as a measurement distance, based on the amount of electric charges accumulated in each of the charge accumulation units CS.

The distance image processor 4 includes a timing controller 41, a distance calculator 42, and a measurement controller 43.

The timing controller 41 controls timing in which various control signals required for measurement are output, under the control of the measurement controller 43. The various control signals here include, for example, a signal for controlling emission of the light pulse PO, a signal for distributing the reflected light RL to the plurality of charge accumulation units CS and for accumulating the distributed light, a signal for controlling the number of accumulations per frame, and the like. The number of accumulations is the number of times by which processing of distributing and accumulating electric charges in the charge accumulation unit CS is repeated, and is the number of distributions by which a frame cycle is set in advance in. Product of the number of accumulations and a time width (accumulation time width) for accumulating electric charges in each charge accumulation unit CS per process of distributing and storing electric charges is an exposure time.

The distance calculator 42 outputs distance information obtained by calculating a distance to the subject OB based on a pixel signal output from the distance image calculation element 1. The distance calculator 42 calculates a delay time from when the light pulse PO is emitted to when the reflected light RL is received, based on the amount of electric charges accumulated in the plurality of charge accumulation units CS. The distance calculator 42 calculates a distance to the subject OB according to the calculated delay time.

With such a configuration, in the distance image capturing device 100, the light receiver 3 receives the reflected light RL obtained by reflecting the light pulse PO in the near-infrared wavelength band emitted to the subject OB by the light source 2 from the subject OB, and the distance image processor 4 outputs distance information (a distance image) obtained by measuring a distance to the subject OB.

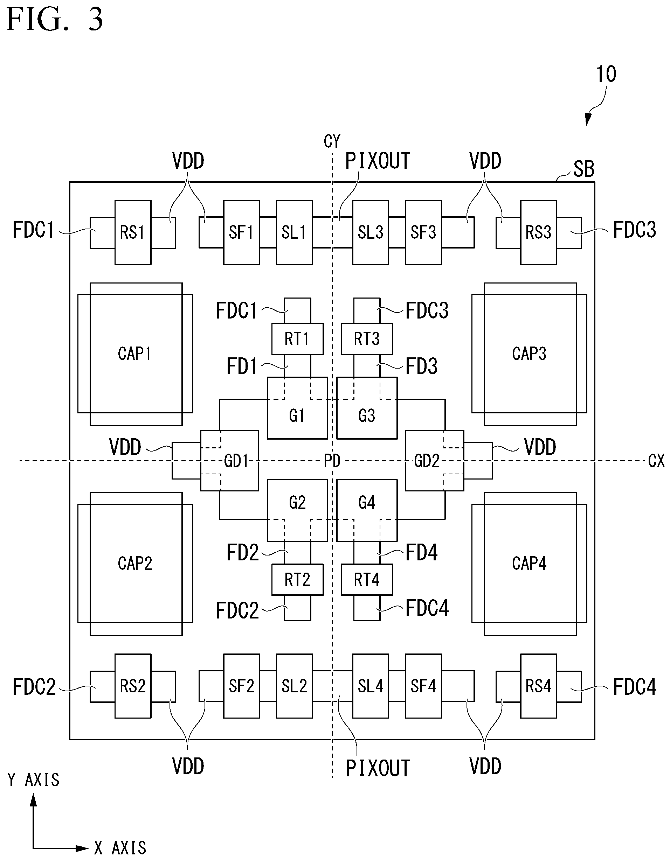

Next, a detailed configuration of the pixel 10 according to the present embodiment will be described with reference to FIGS. 3 to 7.
FIG. 3 is a diagram showing a layout example of the pixel 10 in the present embodiment.

As shown in FIG. 3, the pixel 10 in the present embodiment includes one photoelectric conversion element PD, four transfer transistors G (G1 to G4), two charge emission transistors GD (GD1 and GD2), four reset transistors RT (RT1 to RT4), four capacitors CAP (CAP1 to CAP4), four source follower transistors SF (SF1 to SF4), four selection transistors SL (SL1 to SL4), and four control transistors RS (RS1 to RS4) formed on a semiconductor substrate SB.

In FIG. 3, a horizontal axis in a plan view is an X-direction axis, and a vertical axis in a plan view is a Y-direction axis. The photoelectric conversion element PD is disposed at the center of the semiconductor substrate SB of the pixel 10, two charge emission transistors GD (GD1 and GD2) are disposed on the left and right sides of an X-direction axis, and two transfer transistors G (G1 and G3) and two transfer transistors G (G2 and G4) are disposed above and below a Y-axis direction.

A reset transistor RT1 is connected to the transfer transistor G1, and a reset transistor RT2 is connected to the transfer transistor G2. The reset transistor RT3 is connected to the transfer transistor G3, and the reset transistor RT4 is connected to the transfer transistor G4.

The four capacitors CAP (CAP1 to CAP4) are disposed to be line-symmetrical to each other with respect to an X-axis center line CX and a Y-axis center line CY.

The selection transistor SL1, the source follower transistor SF1, and the control transistor RS1 are disposed above the capacitor CAP1 and the reset transistor RT1.

The selection transistor SL2, the source follower transistor SF2, and the control transistor RS2 are disposed below the capacitor CAP2 and the reset transistor RT2.

The selection transistor SL3, the source follower transistor SF3, and the control transistor RS3 are disposed above the capacitor CAP3 and the reset transistor RT3.

The selection transistor SL4, the source follower transistor SF4, and the control transistor RS4 are disposed below the capacitor CAP4 and the reset transistor RT4.

In the pixel 10, the four control transistors RS are provided, the number of which is the same as the number of capacitors CAP which are charge accumulation units CS to be described below, and the four control transistors RS (RS1 to RS4) are disposed to be line-symmetrical to each other with respect to the X-axis center line CX and the Y-axis center line CY.

As shown in FIG. 3, in the pixel 10, each constituent element is disposed to be line-symmetrical to each other with respect to the X-axis center line CX and the Y-axis center line CY.

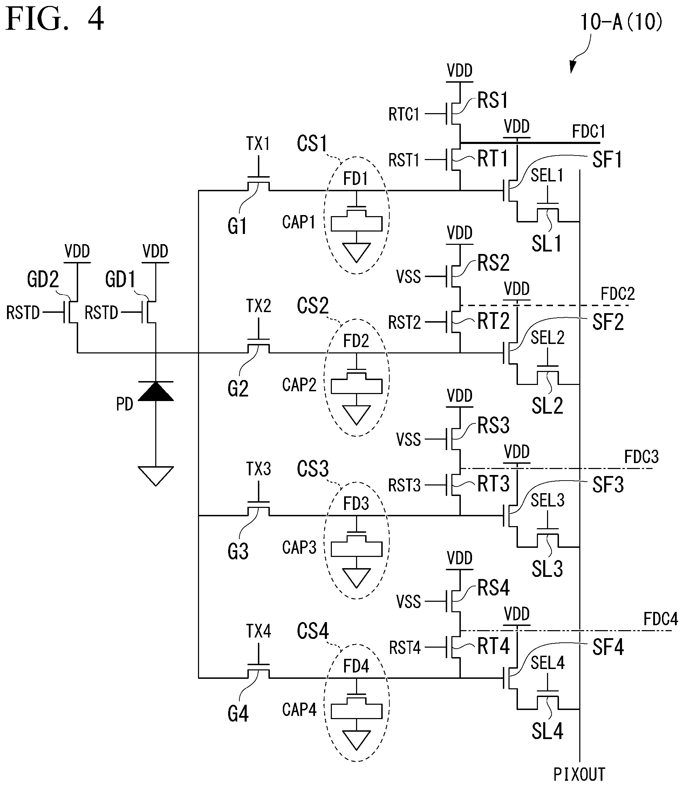

FIGS. 4 to 7 are diagrams showing examples of the pixel 10 in the present embodiment.

The pixel 10 of the present embodiment includes four control transistors RS (RS1 to RS4) that are the same in number as charge accumulation units CS (capacitors CAP) to perform drive of a binning mode, and four types of pixels 10 (pixels 10-A to 10-B) in which the signal connections of control terminals of the four control transistors RS (RS1 to RS4) are different from each other are present.

In the examples shown in FIGS. 3 to 7, an example of a case where the number of charge accumulation units CS (capacitors CAP), which is N (N is an integer of 2 or more), is four (N = 4) will be described.

FIG. 4 shows an example of a pixel 10-A which is a pixel of a type A (hereinafter, referred to as a pixel A) in the present embodiment.

The example of the pixel 10 shown in FIGS. 4 to 7 describes an example of a case where (4×4) pixels 10 are binned.

As shown in FIG. 4, the pixel 10-A includes one photoelectric conversion element PD, four transfer transistors G (G1 to G4), two charge emission transistors GD (GD1 and GD2), four reset transistors RT (RT1 to RT4), four capacitors CAP (CAP1 to CAP4), four source follower transistors SF (SF1 to SF4), four selection transistors SL (SL1 to SL4), and four control transistors RS (RS1 to RS4).

The photoelectric conversion element PD is an embedded photodiode that photoelectrically converts incident light, generates electric charges corresponding to the incident light, and accumulates the generated electric charges. In the present embodiment, the incident light is incident from a space of a measurement target. An anode terminal of the photoelectric conversion element PD is connected to a ground power supply line, and a cathode terminal of the photoelectric conversion element PD is connected to source terminals of the transfer transistor G (G1 to G4).

In the pixel 10-A (10), the photoelectric conversion element PD distributes the electric charges generated by photoelectrically converting the incident light to each of the four charge accumulation units CS (CS1 to CS4), and outputs each of voltage signals corresponding to the amount of the distributed electric charges to an output line PIXOUT.

The pixel drive circuit 12 synchronizes with the irradiation of the light pulse PO in a frame cycle under the control of the measurement controller 43, and accumulates the electric charges generated by the photoelectric conversion element PD in the charge accumulation units CS1, CS2, CS3, and CS4 in this order by supplying and redirecting the accumulation control signals TX (TX1 to TX4) to the transfer transistors G (G1, G2, G3, G4) at each timing.

The charge accumulation units CS are composed of floating diffusions FD and capacitors CAP. That is, the charge accumulation unit CS1 is composed of a floating diffusion FD1 and a capacitor CAP1, and the charge accumulation unit CS2 is composed of a floating diffusion FD2 and a capacitor CAP2. The charge accumulation unit CS3 is composed of a floating diffusion FD3 and a capacitor CAP3, and the charge accumulation unit CS4 is composed of a floating diffusion FD4 and a capacitor CAP4.

The floating diffusions FD (FD1 to FD4) are wiring lines between the transfer transistors G (G1 to G4) and the source follower transistors SF (SF1 to SF4).

The capacitors CAP (CAP1 to CAP4) are, for example, CMOS capacitors.

The transfer transistors G (G1 to G4) are brought into conductive states (ON states) according to control signals TX (TX1 to TX4), and electric charges generated by the photoelectric conversion element PD are accumulated in the charge accumulation units CS (CS1 to CS4) and transferred to the source follower transistors SF (SF1 to SF4).

The source follower transistors SF (SF1 to SF4) are transistors that convert electric charges into electrical signals, and output electrical signals (voltages) corresponding to the electric charges accumulated in the charge accumulation units CS (CS1 to CS4) to the selection transistors SL (SL1 to SL4).

The selection transistors SL (SL1 to SL4) select reading of the electrical signals of the pixel 10. The selection transistors SL (SL1 to SL4) are brought into conductive states (ON states) according to control signals SEL (SEL1 to SEL4) and output pixel values (output signals) to output lines PIXOUT.

Each reset transistor RT (RT1 to RT4) corresponds to each charge accumulation unit CS (CS1 to CS4) and reset each charge accumulation unit CS (CS1 to CS4) to predetermined reset potentials supplied from power supply lines VDD. The reset transistors RT (RT1 to RT4) are brought into conductive states (ON states) according to control signals RST (RST1 to RST4) and reset the charge accumulation units CS (CS1 to CS4) to a reset potential supplied from the power supply line VDD through the control transistors RS (RS1 to RS4) to be described below.

The control transistors RS (RS1 to RS4) are control transistors RS corresponding to the reset transistors RT (RT1 to RT4), and are connected between the reset transistors RT (RT1 to RT4) and the power supply line VDD. Wiring lines between the control transistors RS (RS1 to RS4) and the reset transistors RT (RT1 to RT4) function as floating diffusions FDC (FDC1 to FDC4) that output the added electric charges in a binning mode in which a plurality of pixels 10 are added and used.

A control terminal of at least one (the control transistor RS1 of the pixel A) of the four control transistors RS (RS1 to RS4) is connected to a wiring line (control wiring line) of the control signal RTC1 capable of controlling an ON state of the control transistor RS. The remaining control terminals of the four control transistors RS (RS1 to RS4) other than at least one control transistor (other than the control transistor RS1 in the pixel A) are connected to the power supply line VSS such that the control transistors RS are fixed in an OFF state.

In the pixel A (pixel 10-A), the floating diffusion FDC1 is brought into an ON state by a wiring line (control wiring line) of the control signal RTC1 and is reset to a reset potential supplied from the power supply line VDD.

The two charge emission transistors GD (GD1 and GD2) are connected between the photoelectric conversion element PD and the power supply line VDD, and emits electric charges from the photoelectric conversion element PD. The charge emission transistors GD (GD1 and GD2) are turned on according to a control signal RSTD and the electric charges generated in the photoelectric conversion element PD flow to the power supply line VDD to be discharged (the electric charges are erased).

The transfer transistors G (G1 to G4), the charge emission transistors GD (GD1 and GD2), the reset transistors RT (RT1 to RT4), the source follower transistors SF (SF1 to SF4), the selection transistors SL (SL1 to SL4), and the control transistors RS (RS1 to RS4) are n-channel metal oxide semiconductor (NMOS) transistors.

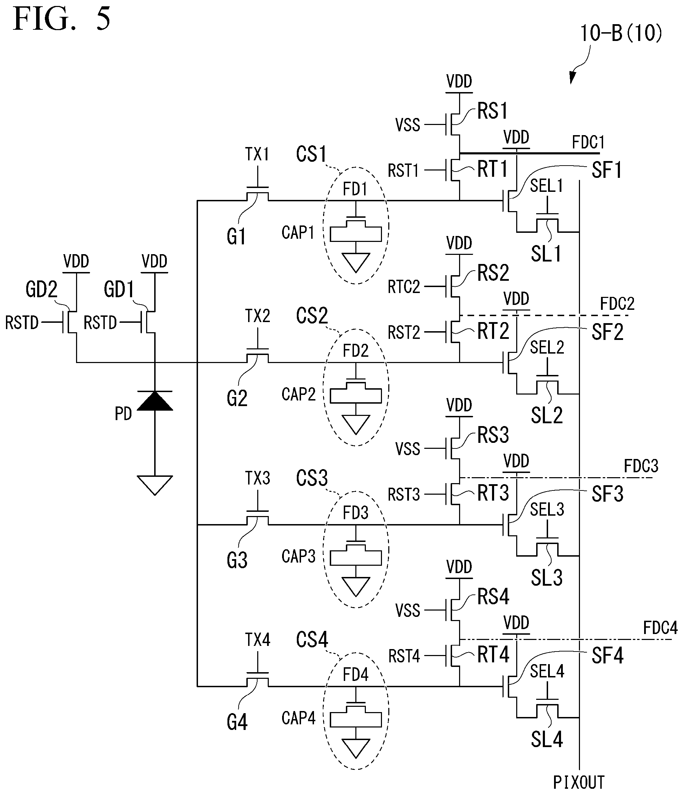

FIG. 5 shows an example of a pixel 10-B which is a pixel of a type B (hereinafter, referred to as a pixel B) in the present embodiment.

The pixel 10-B shown in FIG. 5 has the same basic configuration as the pixel 10-A described above, but connection of control signals (control wiring lines) of the control transistors RS (RS1 to RS4) are different therefrom.

In the pixel 10-B shown in FIG. 5, a control terminal of at least one (the control transistor RS2 in the pixel B) of four control transistors RS (RS1 to RS4) is connected to a wiring line (control wiring line) of a control signal RTC2 capable of controlling an ON state of the control transistor RS. The remaining control terminals of the four control transistors RS (RS1 to RS4) other than at least one control transistor (other than the control transistor RS2 in the pixel B) are connected to a power supply line VSS such that the control transistors RS are fixed in an OFF state.

In the pixel B (pixel 10-B), a floating diffusion FDC2 is brought into an ON state by the wiring line (control wiring line) of the control signal RTC2, and is reset to a reset potential supplied from a power supply line VDD.

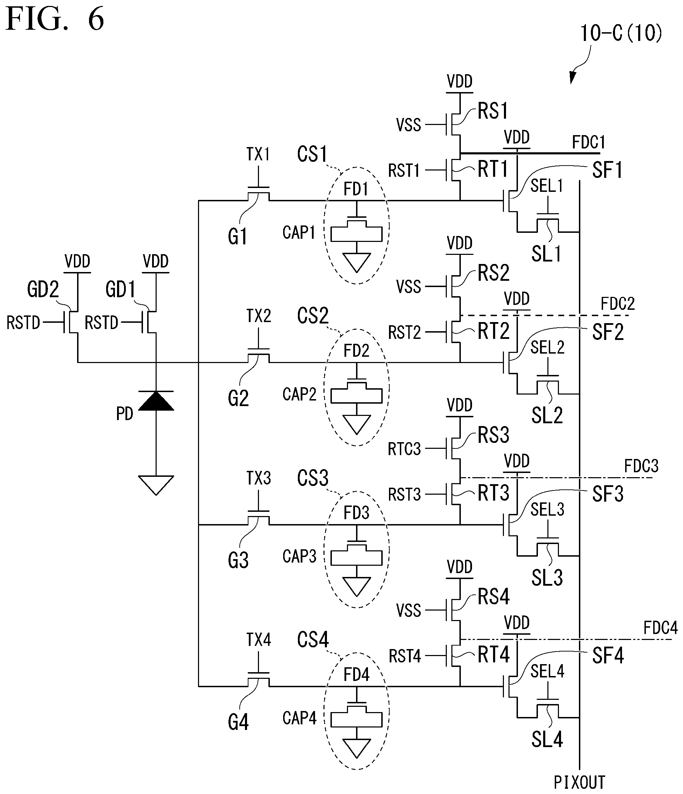

FIG. 6 shows an example of a pixel 10-C which is a pixel of a type C (hereinafter, referred to as a pixel C) in the present embodiment.

The pixel 10-C shown in FIG. 6 has the same basic configuration as the pixel 10-A described above, but connections of control signals (control wiring lines) of the control transistors RS (RS1 to RS4) are different therefrom.

In the pixel 10-C shown in FIG. 6, a control terminal of at least one (a control transistor RS3 in the pixel C) of four control transistors RS (RS1 to RS4) is connected to a wiring line (control wiring line) of a control signal RTC3 capable of controlling an ON state of the control transistor RS. The remaining control terminals of the four control transistors RS (RS1 to RS4) other than at least one control transistor (other than the control transistor RS3 in the pixel C) are connected to a power supply line VSS such that the control transistors RS are fixed in an OFF state.

In the pixel C (pixel 10-C), a floating diffusion FDC3 is brought into an ON state by a wiring line (control wiring line) of the control signal RTC3 and is reset to a reset potential supplied from a power supply line VDD.

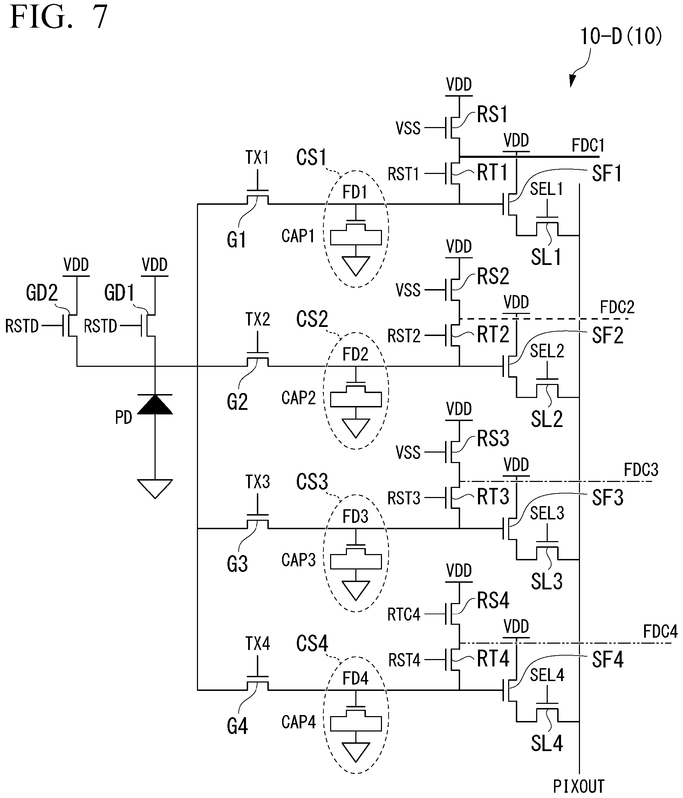

FIG. 7 shows an example of a pixel 10-D which is a pixel of a type D (hereinafter, referred to as a pixel D) in the present embodiment.

The pixel 10-D shown in FIG. 7 has the same basic configuration as the pixel 10-A described above, but connections of control signals (control wiring lines) of the control transistors RS (RS1 to RS4) are different therefrom.

In the pixel 10-D shown in FIG. 7, a control terminal of at least one (a control transistor RS4 in the pixel D) of four control transistors RS (RS1 to RS4) is connected to a wiring line (control wiring line) of a control signal RTC4 that is capable of controlling an ON state of the control transistor RS. The remaining control terminals of the four control transistors RS (RS1 to RS4) other than at least one control transistor (other than the control transistor RS4 in the pixel D) are connected to a power supply line VSS such that the control transistors RS are fixed in an OFF state.

In the pixel D (pixel 10-D), a floating diffusion FDC4 is brought into an ON state by the wiring line (control wiring line) of the control signal RTC4, and is reset to a reset potential supplied from a power supply line VDD.

As described above, in each of the four types of pixels 10 of the pixels A to D, among the four (N examples) control transistors RS (RS1 to RS4), positions of the control transistors RS connected to wiring lines of the control signals RTC (RTC1 to RTC4) are different from each other.

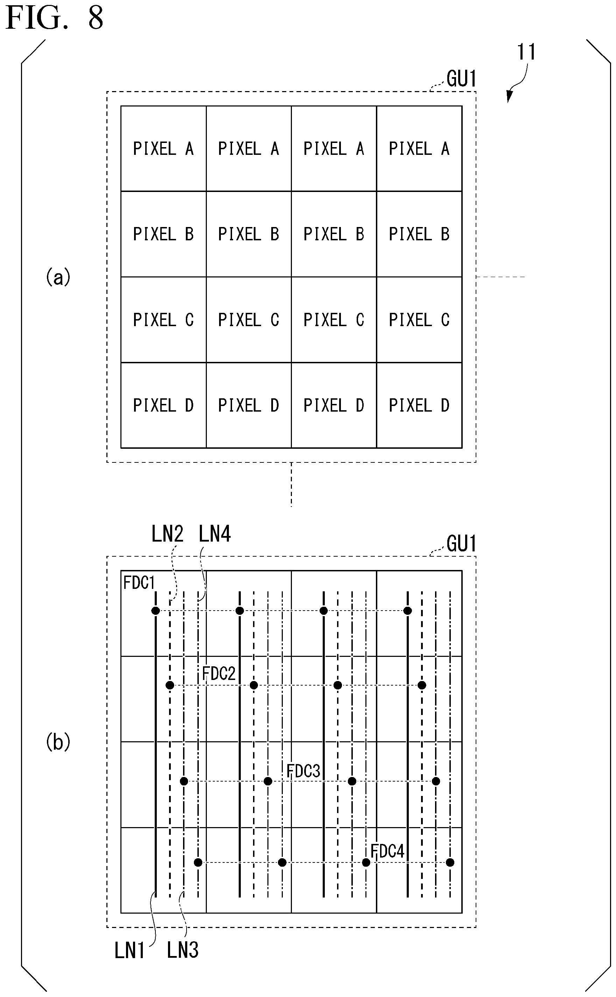

Next, a configuration of the pixel array 11 will be described with reference to FIG. 8.

FIG. 8 is a diagram showing an example of the pixel array 11 in the present embodiment.

As shown in FIG. 8 (a), the pixel array 11 has four types (an example of a type K) of pixels 10 including pixels A to D (here, K is an integer of N or less, which is the number of the charge accumulation units CS).

In the pixel array 11, the four types of pixels 10 (pixels 10-A to 10-D) are disposed in one row (for example, horizontal one row in FIG. 8 (a)), and a pixel unit GU1 (unit pixel structure) composed of a matrix of four types × four pieces (4×4 matrix) is formed on a semiconductor substrate SB. The pixel array 11 is formed by repeating the pixel unit GU1.

FIG. 8 (b) shows a wiring line example of the pixel array 11 of FIG. 8 (a).

In FIG. 8 (b), a wiring line LN1 indicates a wiring line of a floating diffusion FDC1, and a wiring line LN2 indicates a wiring line of a floating diffusion FDC2. A wiring line LN3 indicates a wiring line of a floating diffusion FDC3, and a wiring line LN4 indicates a wiring line of a floating diffusion FDC4.

The wiring line LN1 to the wiring line LN4, which are wiring lines of the floating diffusions FDC (FDC1 to FDC4), are drawn out to an upper layer wiring line of the semiconductor substrate SB and wired.

By disposing each of the pixels 10-A to 10-D in horizontal one row with the same type of pixels, the wiring line LN1 to the wiring line LN4 of the floating diffusions FDC (FDC1 to FDC4) can be wired in a straight line as shown in FIG. 8 (b), and can be wired to be the shortest.

Next, an operation of the distance image capturing element 1 according to the present embodiment will be described with reference to the drawings.

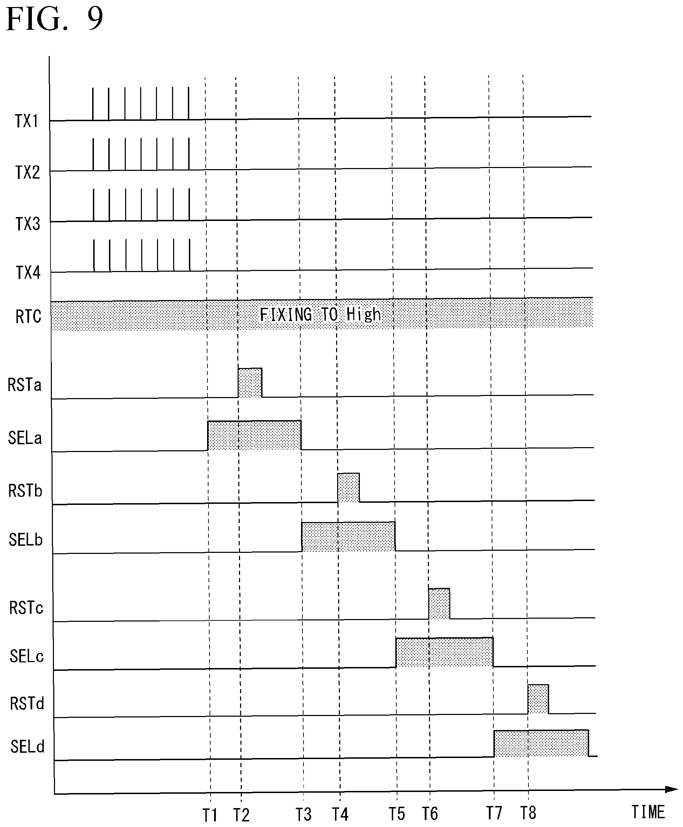

FIG. 9 is a timing chart showing an example of the operation of the distance image capturing element 1 according to the present embodiment in the normal mode.

In FIG. 9, a horizontal axis represents time, and a vertical axis represents waveforms of control signals TX1 to TX4, a control signal RTC, a control signal RSTa, a control signal SELa, a control signal RSTb, a control signal SELb, a control signal RSTc, a control signal SELc, a control signal RSTd, and a control signal SELd in this order from the top.

In FIG. 9, a reset signal (control signal RST) that is transmitted to the pixel A is referred to as the control signal RSTa, and a control signal SEL that is transmitted to the pixel A is referred to as the control signal SELa. A reset signal (control signal RST) that is transmitted to the pixel B is referred to as the control signal RSTb, and a control signal SEL that is transmitted to the pixel B is referred to as the control signal SELb.

In addition, likewise, a reset signal (control signal RST) that is transmitted to the pixel C is referred to as the control signal RSTc, and a control signal SEL that is transmitted to the pixel C is referred to as the control signal SELc. A reset signal (control signal RST) that is transmitted to the pixel D is referred to as the control signal RSTd, and a control signal SEL that is transmitted to the pixel D is referred to as the control signal SELd.

First, in the normal mode shown in FIG. 9, the pixel drive circuit 12 fixes the control signal RTC to a high (H) state and fixes the control transistors RS (RS1 to RS4) to an on state.

As shown in FIG. 9, during a period until a time point T1, the pixel drive circuit 12 brings the transfer transistors G (G1 to G4) into an ON state according to the control signals TX (TX1 to TX4) to accumulate electric charges in the charge accumulation units CS (CS1 to CS4).

Next, at the time point T1, the pixel drive circuit 12 sets the control signal SELa (SEL1 to SEL4) to an H state and outputs a pixel value (output signal) of the pixel A to the output line PIXOUT.

Next, at a time point T2, the pixel drive circuit 12 sets the control signal RSTa (RST1 to RST4) to an H state to reset the charge accumulation units CS (CS1 to CS4) of the pixels A.

Next, at a time point T3, the pixel drive circuit 12 sets the control signal SELb (SEL1 to SEL4) to an H state and outputs a pixel value (output signal) of the pixel B to the output line PIXOUT.

Next, at a time point T4, the pixel drive circuit 12 sets the control signal RSTb (RST1 to RST4) to an H state to reset the charge accumulation units CS (CS1 to CS4) of the pixels B.

Next, at a time point T5, the pixel drive circuit 12 sets the control signal SELc (SEL1 to SEL4) to an H state and outputs a pixel value (output signal) of the pixel C to the output line PIXOUT.

Next, at a time point T6, the pixel drive circuit 12 sets the control signal RSTc (RST1 to RST4) to an H state to reset the charge accumulation units CS (CS1 to CS4) of the pixels C.

Next, at a time point T7, the pixel drive circuit 12 sets the control signal SELd (SEL1 to SEL4) to an H state and outputs a pixel value (output signal) of the pixel D to the output line PIXOUT.

Next, at a time point T8, the pixel drive circuit 12 sets the control signal RSTd (RST1 to RST4) to an H state to reset the charge accumulation units CS (CS1 to CS4) of the pixels D.

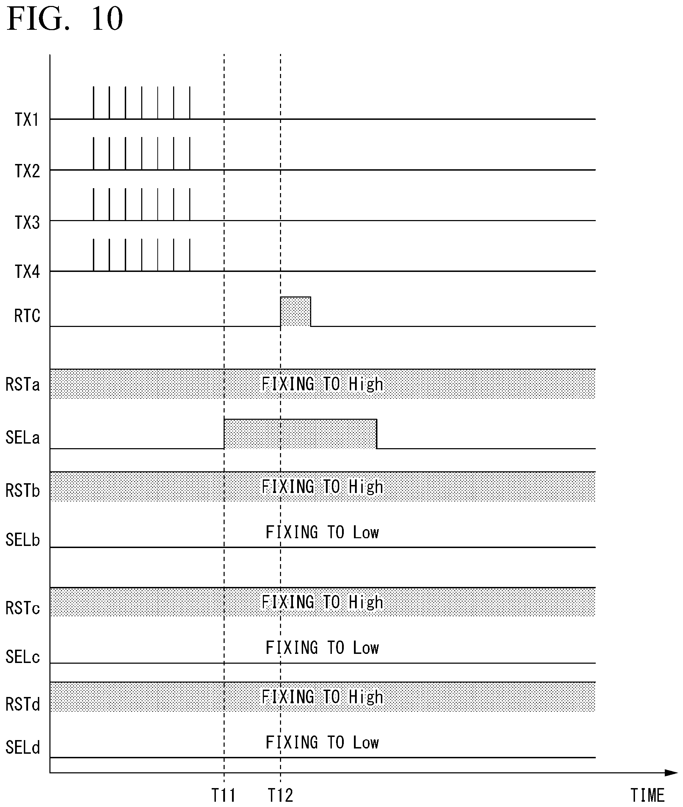

FIG. 10 is a timing chart showing an example of an operation of the distance image capturing element 1 according to the present embodiment in a binning mode of (4×4) pixels.

In FIG. 10, a horizontal axis represents time, and a vertical axis represents waveforms of control signals TX1 to TX4, a control signal RTC, a control signal RSTa, a control signal SELa, a control signal RSTb, a control signal SELb, a control signal RSTc, a control signal SELc, a control signal RSTd, and a control signal SELd in this order from the top.

In FIG. 10, the control signal RSTa, the control signal SELa, the control signal RSTb, the control signal SELb, the control signal RSTc, the control signal SELc, the control signal RSTd, and the control signal SELd are the same as the signals in FIG. 9.

First, in the binning mode shown in FIG. 10, the pixel drive circuit 12 fixes the control signal RSTa, the control signal RSTb, the control signal RSTc, and the control signal RSTd to an H state, and fixes the reset transistors RT (RT1 to RT4) to an ON state. The pixel drive circuit 12 fixes the control signal SELb, the control signal SELc, and the control signal SELd to a low (L) state, and fixes the selection transistors SL (SL1 to SL4) of the pixels B to D to an OFF state.

As shown in FIG. 10, during a period until a time point T11, the pixel drive circuit 12 brings the transfer transistors G (G1 to G4) into an ON state according to the control signals TX (TX1 to TX4) to accumulate electric charges in the charge accumulation units CS (CS1 to CS4).

Next, at the time point T11, the pixel drive circuit 12 sets the control signal SELa (SEL1 to SEL4) to an H state and outputs a pixel value (output signal) corresponding to the electric charges added by the binning from the pixel A to the output line PIXOUT.

Next, at a time point T12, the pixel drive circuit 12 sets the control signal RTC (RTC1 to RTC4) to an H state to reset the charge accumulation units CS (CS1 to CS4) of (4×4) pixels.

As described above, the distance image capturing element 1 according to the present embodiment includes the pixel array 11 in which the plurality of pixels 10 are arranged, and the pixel drive circuit 12 that drives the pixels 10 to distribute and accumulate electric charges in the charge accumulation units CS. The pixel 10 includes the photoelectric conversion element PD that generates electric charges corresponding to incident light and N (here, N is an integer of 2 or more) charge accumulation units CS that accumulate the electric charges. The pixel 10 includes N transfer transistors G, N reset transistors RT, and the control transistor RS. The N transfer transistors G transfer electric charges from the photoelectric conversion element PD to each of the N charge accumulation units CS. The N reset transistors RT are reset transistors RT corresponding to the N charge accumulation units CS, and reset the charge accumulation units CS to a predetermined reset potential supplied from the power supply line VDD. The N control transistors RS are control transistors RS corresponding to the N reset transistors RT and are connected between the reset transistors RT and a power supply line. In the pixel 10, at least one control terminal among the N control transistors RS is connected to a control wiring line capable of controlling a conductive state of the control transistor RS, and the remaining control terminals other than at least one control terminal of the N control transistors RS are connected such that the control transistors RS are fixed in a non-conductive state.

Thereby, the distance image capturing element 1 according to the present embodiment includes the same number of control transistors RS as the charge accumulation units CS, such that the pixels 10 in which the control transistors are present are not mixed with the pixels 10 in which the control transistors are not present, and thus, uniformity of pixel output characteristics can be maintained. Therefore, the distance image capturing element 1 according to the present embodiment can make the pixel output characteristics uniform and improve accuracy of distance measurement.

In the present embodiment, the pixel array 11 has K types (here, K is an integer of N or less) of pixels 10 (for example, four types of the pixels A to D), and the K types of pixels 10 have different positions of the control transistors RS connected to wiring lines of the control signals RTC among the N control transistors RS.

Thereby, the distance image capturing element 1 according to the present embodiment can maintain uniformity of pixel output characteristics while implementing the bringing control, by using K types (for example, four types of pixels A to D) of the pixels 10.

In the present embodiment, K types of pixels 10 are disposed in one row (for example, horizontal one row), and the pixel unit GU1 (unit pixel structure) composed of a matrix of K types × K pieces (for example, (4 × 4) pixels) is formed on the semiconductor substrate SB.

Thereby, in the distance image capturing element 1 according to the present embodiment, wiring lines of the floating diffusions FDC (FDC1 to FDC4) can be formed in a straight line, and the wiring lines can be formed to be the shortest. Therefore, the distance image capturing element 1 according to the present embodiment can reduce parasitic capacitors in the wiring lines of the floating diffusions FDC (FDC1 to FDC4) and can reduce the influence of noise.

In the present embodiment, the pixel array 11 is formed by repeating the pixel unit GU1.

Thereby, in the distance image capturing element 1 according to the present embodiment, the pixel array 11 is formed by repeating the pixel unit GU1 configured in a matrix of K types × K pieces (for example, (4 × 4) pixels), such that the number of pixels can be safely increased while maintaining uniformity of pixel output characteristics.

In the present embodiment, the pixel 10 includes the source follower transistor SF that converts electric charges into an electrical signal, the selection transistor SL that selects reading of an electrical signal of the pixel 10, and the charge emission transistor GD that emits the electric charges from the photoelectric conversion element PD.

Thereby, the distance image capturing element 1 according to the present embodiment can appropriately read out electrical signals of the pixel 10 by using the source follower transistor SF and the selection transistor SL, and can appropriately initialize the photoelectric conversion element PD by the charge emission transistor GD.

The distance image capturing device 100 according to the present embodiment includes the light source 2 that irradiates the subject OB with the light pulse PO, the light receiver 3 that includes the distance image capturing element 1 described above, and the distance image processor 4 that causes the pixel drive circuit 12 to accumulate electric charges in each of the charge accumulation units CS and calculates a distance to a subject based on the amount of electric charges accumulated in each of the charge accumulation units CS.

Thereby, the distance image capturing device 100 according to the present embodiment has the same effect as the distance image capturing element 1 described above, and can make the pixel output characteristics uniform and improve accuracy of distance measurement.

The present invention is not limited to the above-described embodiments and can be modified without departing from the gist of the present invention.

For example, in the above-described embodiments, an example is described in which the photoelectric conversion element PD is an embedded photodiode that photoelectrically converts incident light to generate electric charges and accumulates the generated electric charges, but the present invention is not limited thereto, and a structure of the photoelectric conversion element PD may be optional. The photoelectric conversion element PD may be, for example, a PN photodiode having a structure in which a P-type semiconductor and an N-type semiconductor are bonded together, or a PIN photodiode having a structure in which an I-type semiconductor is interposed between the P-type semiconductor and the N-type semiconductor. The photoelectric conversion element PD is not limited to the photodiode and may be, for example, a photogate-type photoelectric conversion element.

Although the above-described embodiment describes an example in which the pixel 10 includes four charge accumulation units CS, the present invention is not limited thereto, and the pixel 10 may include another number (N) of charge accumulation units CS as long as two or more charge accumulation units CS are provided. The number (N) of charge accumulation units CS may be an even number.

Although the above-described embodiment describes an example in which the pixel array 11 includes four types of pixels 10 as an example of K types of pixels 10, the present invention is not limited thereto. For example, in a case where binning of (2×2) pixels is performed, the pixel 10 may include two types of pixels. For example, in a case where binning of (3×3) pixels is performed, three types of pixels 10 may be provided.

Although the above-described embodiment describes an example in which the same type of pixels 10 are disposed side by side in a horizontal one row in the pixel array 11, the present invention is not limited thereto, and for example, the same type of pixels 10 may be disposed side by side in a vertical one row.

Although he above-described embodiment describes an example in which each of the transfer transistors G (G1 to G4), the charge emission transistors GD (GD1 and GD2), the reset transistors RT (RT1 to RT4), the source follower transistors SF (SF1 to SF4), the selection transistors SL (SL1 to SL4), and the control transistors RS (RS1 to RS4) is an NMOS transistor, the present invention is not limited thereto, and for example, other transistors such as PMOS transistors may be used.

Each configuration of the distance image capturing device 100 or the pixel drive circuit 12 described above includes a computer system therein. A program for performing functions of each configuration provided in the distance image capturing device 100 or the pixel drive circuit 12 may be recorded on a computer-readable recording medium, and the program recorded on the recording medium may be loaded into a computer system and executed to perform processing of each configuration provided in the distance image capturing device 100 or the pixel drive circuit 12. The configuration "a computer system reads a program recorded in a recording medium and executes the program" includes installing the program in the computer system. It is assumed that the term "computer system" described here includes an OS and hardware such as a peripheral device.

The "computer system" may include a plurality of computer devices connected through a network including a communication line such as the Internet, a WAN, a LAN, or a dedicated line. The term "computer-readable recording medium" means a storage device, for example, a portable medium, such as a flexible disk, a magneto-optical disk, ROM, or a CD-ROM, a hard disk provided in the computer system, or the like. In this way, a recording medium on which a program is stored may be a non-transitory recording medium such as a CD-ROM.

The recording medium also includes an internal or external recording medium that is accessible by a distribution server for distributing a program. A configuration in which a program is divided into multiple parts and the multiple parts are downloaded at different timings and then are combined into each component included in distance image capturing device 100 or the pixel drive circuit 12, and a distribution server that distributes each of the divided parts of the program may be different from each other. Furthermore, it is assumed that the "computer-readable recording medium" also includes a medium that stores a program for a certain period of time, such as a volatile memory (RAM) provided in a computer system that serves as a server or a client in a case where the program is transmitted through a network. The above-described program may be a program for implementing some of the above-described functions. Furthermore, the program may be a so-called difference file (difference program) capable of implementing the functions described above in combination with a program previously recorded in a computer system.

Some or all of the functions described above may be implemented as an integrated circuit such as a large scale integration (LSI). Each of the functions described above may be individually integrated into a processor, or some or all of the functions may be integrated into a processor. A method for making an integrated circuit is not limited to the LSI, but may be implemented by a dedicated circuit or a general-purpose processor. In a case where an integrated circuit technology emerges to replace the LSI due to advances in semiconductor technology, an integrated circuit using the technology may be used.

## Claims

1. A distance image capturing element comprising:
a pixel array in which a plurality of pixels are arranged, each pixel including a photoelectric conversion element configured to generate electric charges corresponding to incident light and N (where, N is an integer of 2 or more) charge accumulation units configured to accumulate the electric charges; and
a pixel drive circuit configured to drive the plurality of pixels to distribute and accumulate the electric charges in each of the charge accumulation units,
wherein each of the plurality of pixels includes
N transfer transistors configured to transfer the electric charges from the photoelectric conversion element to each of the N charge accumulation units,
N reset transistors which are reset transistors corresponding to each of the N charge accumulation units and are configured to reset the charge accumulation units to a predetermined reset potential supplied from a power supply line, and
N control transistors which are control transistors corresponding to the N reset transistors and are connected between the reset transistors and the power supply line, and
in each of the plurality of pixels, at least one control terminal among the N control transistors is connected to a control wiring line configured to control a conductive state of the control transistor, and remaining control terminals other than the at least one control terminal among the N control transistors are connected to fix the remaining control transistors in a non-conductive state.

2. The distance image capturing element according to Claim 1,
wherein the number of the N charge accumulation units is an even number.

3. The distance image capturing element according to Claim 1,
wherein the pixel array includes K types (where K is an integer of N or less) of the pixels, and each of the K type of pixels has different positions of the control transistors connected to the control wiring line among the N control transistors.

4. The distance image capturing element according to Claim 3,
wherein the K types of pixels are disposed in one row, and
a unit pixel structure composed of K types × K matrixes is formed on a semiconductor substrate.

5. The distance image capturing element according to Claim 4,
wherein the pixel array is formed by repeating the unit pixel structure.

6. The distance image capturing element according to Claim 5,
wherein the pixel includes
a source follower transistor configured to convert the electric charges into an electrical signal,
a selection transistor configured to select reading of the electrical signal of the pixel, and
a charge emission transistor configured to emit the electric charges from the photoelectric conversion element.

7. The distance image capturing element according to Claim 1,
wherein the pixel array includes K types (where K is an integer of N or less) of the pixels, and each of the K type of pixels has different positions of the control transistors connected to the control wiring line among the N control transistors,
wherein the K types of pixels are disposed in one row, and
a unit pixel structure composed of K types × K matrixes is formed on a semiconductor substrate,
wherein the pixel array is formed by repeating the unit pixel structure, and
wherein the pixel includes
a source follower transistor configured to convert the electric charges into an electrical signal,
a selection transistor configured to select reading of the electrical signal of the pixel, and
a charge emission transistor configured to emit the electric charges from the photoelectric conversion element.

8. A distance image capturing device comprising:
a light source configured to irradiate a subject with a light pulse;
a light receiver including the distance image capturing element according to any one of Claims 1 to 7; and
a distance image processor configured to cause the pixel drive circuit to accumulate the electric charges in each of the charge accumulation units and calculate a distance to the subject based on an amount of the electric charges accumulated in each of the charge accumulation units.
